# EUROPEAN PATENT APPLICATION

(11) **EP 4 672 616 A1**
(43) Date of publication of application: **31.12.2025**
(21) Application number: 24777489.6
(22) Date of filing: 29.01.2024
(51) Int. Cl.: H03M 13/27, H04L 1/00

(54) **DATA PROCESSING METHOD AND DATA PROCESSING APPARATUS**

(30) Priority: 31.03.2023 CN 202310386404
(71) Applicant: Huawei Cloud Computing Technologies Co., Ltd., Shenzhen, Guangdong 518129 (CN)
(72) Inventor: YANG, Xiaoling, Shenzhen, Guangdong 518129 (CN); HUANG, Kechao, Shenzhen, Guangdong 518129 (CN); MA, Huixiao, Shenzhen, Guangdong 518129 (CN)
(74) Representative: Huawei European IPR
(86) International application number: PCT/CN2024/074468
(87) International publication number: WO 2024/198694

(57) **Abstract**

Embodiments of this application disclose a data processing method and a data processing apparatus, so that good performance of a concatenated FEC-based solution can be achieved in a scenario with a low latency. For a concatenated FEC-based transmission solution, interleaving alignment needs to be first performed before convolutional interleaving is performed on a first data stream, to determine a boundary of each bit set in the first data stream and a boundary of each bit subset in the bit set. Further, bit subsets are sent as a granularity to each storage unit in a convolutional interleaving operation. In other words, each bit subset includes d bits, and each storage unit is configured to store d bits. The bits in each bit subset are from v symbols, and the v symbols are respectively from v first codewords. In other words, one symbol is selected from each of the v first codewords to form a bit subset.

## Description

This application claims priority to Chinese Patent Application No. 202310386404.8, filed with the China National Intellectual Property Administration on March 31, 2023 and entitled "DATA PROCESSING METHOD AND DATA PROCESSING APPARATUS", which is incorporated herein by reference in its entirety.

### TECHNICAL FIELD

This application relates to the field of optical communication, and in particular, to a data processing method and a data processing apparatus.

### BACKGROUND

With the continuous promotion of 5G, cloud computing, big data, artificial intelligence, and the like, an optical communication system and an optical transport network (optical transport network, OTN) are evolving in the direction that features large capacity and ultra-high speed. Forward error correction (forward error correction, FEC) encoding is used to correct transmitted data, and resolve transmission bit errors to restore, from received data, original data sent by a transmitter.

Currently, a concatenated FEC-based transmission solution is proposed, and a transmitter device is connected to a transmitter processing module through an attachment unit interface (attachment unit interface, AUI). The transmitter device performs first FEC encoding on to-be-transmitted data, and sends data obtained through the first FEC encoding to the transmitter processing module. The transmitter processing module then performs second FEC encoding on the data obtained through the first FEC encoding, and transmits, to a data receiver through a channel, data obtained through the second FEC encoding. Specifically, the transmitter processing module receives a plurality of lanes of data streams, first separately performs convolutional interleaving on the plurality of lanes of data streams, and then performs second FEC encoding on each lane of data stream obtained through the convolutional interleaving. However, in a current solution, convolutional interleaving needs a long latency to achieve good performance, and application effect is not ideal in a scenario requiring a low latency.

### SUMMARY

Embodiments of this application provide a data processing method and a data processing apparatus, so that good performance of a concatenated FEC-based solution can be achieved in a scenario with a low latency.

According to a first aspect, an embodiment of this application provides a data processing method. The method includes the following steps. First, m first data streams are obtained, where m is an integer greater than 1. Each of the first data streams is obtained by interleaving v lanes of first codewords obtained through first FEC encoding, and each of the first data streams includes a plurality of consecutive bit sets. Each of the bit sets includes t bit subsets, and t is an integer greater than 1. Each of the bit subsets includes d bits, d=v×s, v is an integer greater than 1, s indicates a quantity of bits included in each symbol in the first codeword, and s is an integer greater than or equal to 1. The bits in each of the bit subsets are from v symbols, the v symbols are respectively from v first codewords, and the v first codewords are respectively from the v lanes of first codewords. Further, a first data stream is delayed based on p delay lines to obtain a second data stream, so that a total of m second data streams is obtained. p is an integer greater than 1, quantities of storage units included in the delay lines are different from each other, and a delay line with a smallest quantity of storage units includes zero storage units. A difference between quantities of storage units in every two adjacent delay lines is Q, Q is an integer greater than or equal to 1, and each storage unit is configured to store d bits. Bits in each of the first data streams are sequentially input into the p delay lines based on sequence numbers of the p delay lines, and d bits in one bit subset are input at a time into each delay line and d bits are output at a time from each delay line.

In this implementation, for a concatenated FEC-based transmission solution, interleaving alignment needs to be first performed before convolutional interleaving is performed on the first data stream, to determine a boundary of each bit set in the first data stream and a boundary of each bit subset in the bit set. Further, bit subsets are sent as a granularity to each storage unit in a convolutional interleaving operation. In other words, each bit subset includes d bits, and each storage unit is configured to store d bits. The bits in each bit subset are from v symbols, and the v symbols are respectively from v first codewords. In other words, one symbol is selected from each of the v first codewords to form a bit subset. In cooperation with subsequent convolutional interleaving, a complete outer-code codeword symbol may be mapped to an inner-code codeword with a minimum interleaving delay, and an uncorrectable inner-code codeword results in a maximum of one incorrect symbol of an outer-code codeword associated with the inner-code codeword. This avoids error dispersion into a plurality of symbols of the outer-code codeword and improves performance of a concatenated code.

In some possible implementations, p×d consecutive bits in each of the second data streams are from v×p first codewords. Subsequently, inner-code encoding is performed on every p×d consecutive bits in each second data stream to obtain an inner-code codeword, so that a bit in each inner-code codeword can be mapped to outer-code codewords of a maximum quantity. In this way, the performance of the concatenated code is optimal.

In some possible implementations, a delay line with a largest sequence number in the p delay lines includes zero storage units, and (p × Q + 1) ≥ t. A specific implementation solution for achieving optimal performance of the concatenated code is provided, to enhance implementability of the solution.

In some possible implementations, a delay line with a smallest sequence number in the p delay lines includes zero storage units, and (p × Q- 1) ≥ t. Another specific implementation solution for achieving the optimal performance of the concatenated code is provided, to enhance flexibility of the solution.

In some possible implementations, Q is a multiple of 2, so that a convolutional interleaver is implemented by using a low-frequency clock.

In some possible implementations, the m first data streams are obtained by multiplexing n lane data streams, n is an integer multiple of m, and the first FEC encoding is performed on each of the lane data streams. Each of the lane data streams includes a plurality of alignment markers (Alignment marker, AM), each of the first data streams includes a plurality of AM sets, each of the AM sets includes n/m AMs, and an integer quantity of bit sets is included between start positions of every two adjacent AM sets.

In some possible implementations, obtaining the m first data streams includes: performing interleaving alignment on the first data stream based on at least one AM set, to determine a boundary position of each of the bit sets in the first data stream. In other words, in the first data stream, the boundary position of the bit set is determined by identifying the AM set. In addition, because a length of each bit set is fixed, a boundary of each of other bit sets is determined based on a boundary of one bit set. Further, the boundary of each bit subset in the bit set may be determined based on each bit set whose position is determined.

In some possible implementations, the plurality of bit sets include a first bit set and a second bit set that are adjacent to each other, bits in the first bit set are from v first codewords obtained through the first FEC encoding, and bits in the second bit set are from other v codewords obtained through the first FEC encoding.

In some possible implementations, every v consecutive bits in the bit subset are respectively from v first codewords, or every s consecutive bits in the bit subset are from a same first codeword.

In some possible implementations, m=8, v=4, t=68, s=10, p=3, and Q=23 or 24; or m=4, v=4, t=136, s=10, p=3, and Q=46.

In some possible implementations, after obtaining a total of m second data streams, the method further includes: separately performing second FEC encoding on the m second data streams to obtain m third data streams, where K information bits in each second codeword obtained through the second FEC encoding are from a maximum of p×v different first codewords, and K is an integer multiple of p×d.

According to a second aspect, an embodiment of this application provides a data processing apparatus. The data processing apparatus includes a processing unit and a convolutional interleaver. The processing unit is configured to obtain m first data streams, where m is an integer greater than 1, and each of the first data streams is obtained by interleaving v lanes of first codewords obtained through first FEC encoding. The first FEC encoding is performed on each of the first data streams, each of the first data streams includes a plurality of consecutive bit sets, each of the bit sets includes t bit subsets, and t is an integer greater than 1. Each of the bit subsets includes d bits, d=v×s, v is an integer greater than 1, s indicates a quantity of bits included in each symbol in the first codeword, and s is an integer greater than or equal to 1. The bits in each of the bit subsets are from v symbols, the v symbols are respectively from v first codewords, and the v first codewords are respectively from the v lanes of first codewords. The convolutional interleaver is configured to delay a first data stream based on p delay lines to obtain a second data stream, so that a total of m second data streams is obtained. p is an integer greater than 1, quantities of storage units included in the delay lines are different from each other, and a delay line with a smallest quantity of storage units includes zero storage units. A difference between quantities of storage units in every two adjacent delay lines is Q, Q is an integer greater than or equal to 1, and each storage unit is configured to store d bits. Bits in each of the first data streams are sequentially input into the p delay lines based on sequence numbers of the p delay lines, and d bits in one bit subset are input at a time into each delay line and d bits are output at a time from each delay line.

In some possible implementations, p×d consecutive bits in each of the second data streams are from v×p first codewords.

In some possible implementations, a delay line with a largest sequence number in the p delay lines includes zero storage units, and (p × Q + 1) ≥ t.

In some possible implementations, a delay line with a smallest sequence number in the p delay lines includes zero storage units, and (p × Q- 1) ≥ t.

In some possible implementations, Q is a multiple of 2.

In some possible implementations, the m first data streams are obtained by multiplexing n lane data streams. n is an integer multiple of m, and the first FEC encoding is performed on each of the lane data streams. Each of the lane data streams includes a plurality of AMs, each of the first data streams includes a plurality of AM sets, each of the AM sets includes n/m AMs, and an integer quantity of bit sets is included between start positions of every two adjacent AM sets.

In some possible implementations, the processing unit is specifically configured to perform interleaving alignment on the first data stream based on at least one AM set, to determine a boundary position of each of the bit sets in the first data stream.

In some possible implementations, the plurality of bit sets include a first bit set and a second bit set that are adjacent to each other, bits in the first bit set are from v first codewords obtained through the first FEC encoding, and bits in the second bit set are from other v codewords obtained through the first FEC encoding.

In some possible implementations, every v consecutive bits in the bit subset are respectively from v first codewords, or every s consecutive bits in the bit subset are from a same first codeword.

In some possible implementations, m=8, v=4, t=68, s=10, p=3, and Q=23 or 24; or m=4, v=4, t=136, s=10, p=3, and Q=46.

In some possible implementations, the data processing apparatus further includes an encoder, and the encoder is configured to:
separately perform second FEC encoding on the m second data streams to obtain m third data streams, where K information bits in each second codeword obtained through the second FEC encoding are from a maximum of p×v different first codewords, and K is an integer multiple of p×d.

### BRIEF DESCRIPTION OF DRAWINGS

FIG. 1 is a diagram of a communication system to which an embodiment of this application is applied;
FIG. 2 is a diagram of a data transmission process in the communication system shown in FIG. 1;
FIG. 3 is a diagram of data processing of a transmitter processing module according to an embodiment of this application;
FIG. 4 is a schematic flowchart of a data processing method according to an embodiment of this application;
FIG. 5 is a diagram of a first structure of a first data stream according to an embodiment of this application;
FIG. 6 is a diagram of a second structure of a first data stream according to an embodiment of this application;
FIG. 7 is a diagram of a third structure of a first data stream according to an embodiment of this application;
FIG. 8 is a diagram of a fourth structure of a first data stream according to an embodiment of this application;
FIG. 9 is a diagram of separately performing convolutional interleaving on m first data streams according to an embodiment of this application;
FIG. 10(a) is a diagram of a first structure of a convolutional interleaver according to an embodiment of this application;
FIG. 10(b) is a diagram of a second structure of a convolutional interleaver according to an embodiment of this application;
FIG. 11 is a diagram of performing second FEC encoding on m second data streams according to an embodiment of this application;
FIG. 12 is a diagram of 32 PCS lane data streams when a transmitter device uses a 1×800G interface;
FIG. 13 is a diagram of a fifth structure of a first data stream according to an embodiment of this application;
FIG. 14 is a diagram of a sixth structure of a first data stream according to an embodiment of this application;
FIG. 15 is a diagram of a third structure of a convolutional interleaver according to an embodiment of this application;
FIG. 16 is a diagram of a fourth structure of a convolutional interleaver according to an embodiment of this application;
FIG. 17 is a diagram of a fifth structure of a convolutional interleaver according to an embodiment of this application;
FIG. 18 is a diagram of a seventh structure of a first data stream according to an embodiment of this application;
FIG. 19 is a diagram of a sixth structure of a convolutional interleaver according to an embodiment of this application;
FIG. 20 is a diagram of 16 PCS lane data streams in a 1600GbE scenario;
FIG. 21 is a diagram of an eighth structure of a first data stream according to an embodiment of this application;
FIG. 22 is another diagram of data processing of a transmitter processing module according to an embodiment of this application;
FIG. 23 is a diagram of multiplexing first data streams according to an embodiment of this application;
FIG. 24 is a diagram of a structure of a data processing apparatus according to an embodiment of this application; and
FIG. 25 is a diagram of another structure of a data processing apparatus according to an embodiment of this application.

### DESCRIPTION OF EMBODIMENTS

Embodiments of this application provide a data processing method and a data processing apparatus, so that good performance of a concatenated FEC-based solution can be achieved in a scenario with a low latency. It should be noted that, the terms "first", "second", and the like in the specification, claims, and accompanying drawings of this application are intended to distinguish between similar objects but do not necessarily indicate a specific order or sequence. It should be understood that the foregoing terms are interchangeable in proper circumstances so that embodiments described in this application can be implemented in other orders than the content described in this application. Moreover, the terms "include", "have", or any other variant thereof are intended to cover non-exclusive inclusion. For example, processes, methods, systems, products, or devices that include a series of steps or units are not limited to the steps or the units that are clearly listed, and may include other steps and units that are not clearly listed or that are inherent to the processes, methods, products, or devices.

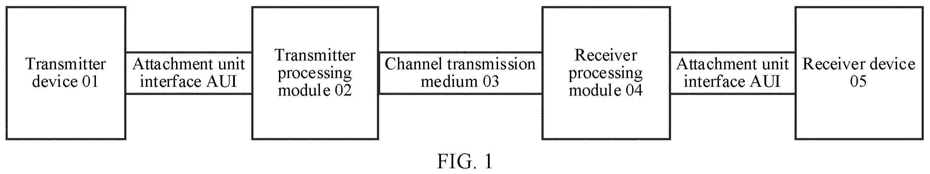

FIG. 1 is a diagram of a communication system to which an embodiment of this application is applied. As shown in FIG. 1, the communication system includes a transmitter device 01, a transmitter processing module 02, a channel transmission medium 03, a receiver processing module 04, and a receiver device 05. For example, the communication system is a data center network. The transmitter device 01 and the receiver device 05 each may be a device such as a switch or a router, the transmitter device 01 is also referred to as a host chip (host chip) located at a transmitter, the receiver device 05 is also referred to as a host chip located at a receiver, and the channel transmission medium 03 may be an optical fiber. The host chip is also sometimes referred to as a host device (host device). The transmitter device 01 may be connected to the transmitter processing module 02 through an attachment unit interface (attachment unit interface, AUI), and the receiver device 05 may be connected to the receiver processing module 04 through an AUI. The transmitter processing module 02 and the receiver processing module 04 each may be an optical module (optical module), an electrical module, a connector (connector), or another module that processes data in a data sending process. For example, the processing module may be an 800GE FR module. In addition, the transmitter device 01, the transmitter processing module 02, the channel transmission medium 03, the receiver processing module 04, and the receiver device 05 in the communication system may all support bidirectional transmission or unidirectional transmission. This is not specifically limited herein.

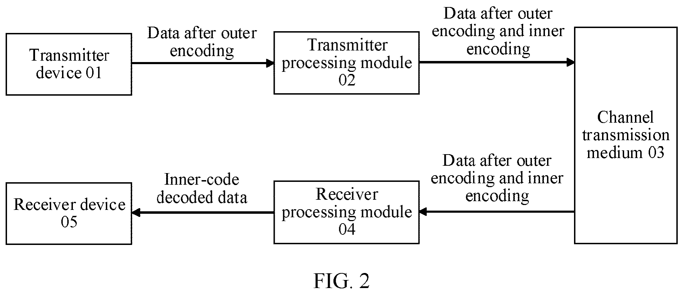

FIG. 2 is a diagram of a data transmission process in the communication system shown in FIG. 1. As shown in FIG. 2, in a process of transmitting data from the transmitter device 01 to the receiver device 05, the transmitter device 01 is configured to: perform outer-code encoding on the data; and then transmit data after outer-code encoding to the transmitter processing module 02. The transmitter processing module 02 is configured to: perform inner-code encoding on the data after outer-code encoding, to obtain data after outer-code encoding and inner-code encoding; and transmit the data after outer-code encoding and inner-code encoding to the channel transmission medium 03. The channel transmission medium 03 is configured to transmit the data after outer-code encoding and inner-code encoding to the receiver processing module 04. The receiver processing module 04 is configured to: perform inner-code decoding on the data after outer-code encoding and inner-code encoding; and transmit data after inner-code decoding to the receiver device 05. The receiver device 05 is configured to perform outer-code decoding on the data after inner-code decoding.

It should be understood that "inner" in an inner code and "outer" in an outer code are distinguished based merely on a distance between the channel transmission medium 03 and an execution body that performs an operation on data. An execution body that performs an operation on the inner code is closer to the channel transmission medium, and an execution body that performs an operation on the outer code is farther away from the channel transmission medium. In embodiments of this application, data is transmitted from the transmitter device 01 to the channel transmission medium 03 via the transmitter processing module 02, and then is transmitted from the channel transmission medium 03 to the receiver device 05 via the receiver processing module 04. A distance between data encoded by the transmitter device 01 and the channel transmission medium 03 is longer than that between data encoded by the transmitter processing module 02 and the channel transmission medium 03, and a distance between data decoded by the receiver device 05 and the channel transmission medium 03 is longer than that between data decoded by the receiver processing module 04 and the channel transmission medium 03. Therefore, the data encoded by the transmitter device 01 is referred to as data after outer-code encoding, the data encoded by the transmitter processing module 02 is referred to as data after inner-code encoding, the data decoded by the receiver device 05 is referred to as data after outer-code decoding, and data decoded by the receiver processing module 04 is referred to as data after inner-code decoding. In a possible implementation, both the inner-code encoding and the outer-code encoding use a FEC encoding scheme, to form a concatenated FEC-based transmission solution. For example, the transmitter device 01 may perform outer-code encoding by using an RS code, and the transmitter processing module 02 may perform inner-code encoding by using a Hamming (Hamming) code. For another example, the transmitter device 01 may perform outer-code encoding by using an RS code, and the transmitter processing module 02 may perform inner-code encoding by using a Bose-Chaudhuri-Hocquenghem (Bose-Chaudhuri-Hocquenghem, BCH) code.

It should be noted that the foregoing content is example description of an application scenario of a data processing method provided in embodiments of this application, and does not constitute any limitation on application scenarios of the data processing method. A person of ordinary skill in the art may learn that, as a service requirement changes, application scenario of the data interleaving method may be adjusted depending on an application requirement. Application scenarios are not enumerated in embodiments of this application.

For the foregoing concatenated FEC-based transmission solution, a data processing method including interleaving alignment and convolutional interleaving is designed in this application, so that the concatenated FEC has an extremely low latency and good performance, can satisfy requirements of more transmission scenarios, and is particularly applicable to a transmission scenario in which a low transmission latency is needed, for example, a low-latency data center internal interconnection scenario. The data processing method is implemented by the foregoing transmitter processing module 02.

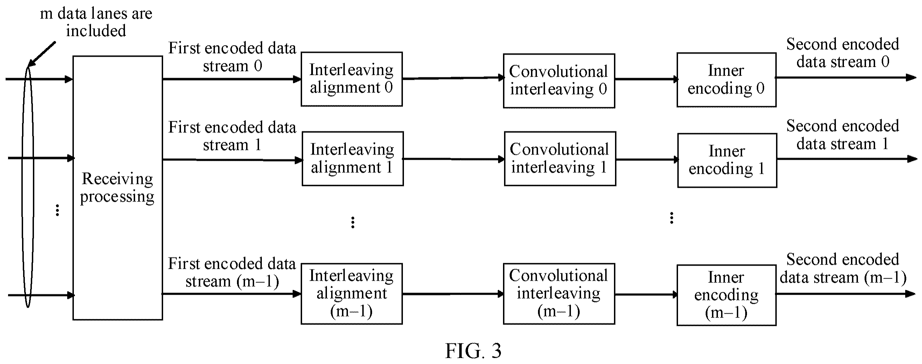

FIG. 3 is a diagram of data processing of a transmitter processing module according to an embodiment of this application. As shown in FIG. 3, the transmitter processing module receives data from an AUI-m interface, where the AUI-m interface includes m data lanes, m is a positive integer greater than 1, and the m data lanes are respectively used to transmit m first encoded data streams. It should be understood that outer-code encoding is performed on each first encoded data stream. In an example, the transmitter device 01 performs outer-code encoding to obtain n physical coding sublayer (Physical Coding Sublayer, PCS) lane data streams or FEC lane data streams, which may be referred to as n lane data streams for short, and each lane data stream is obtained by interleaving u lanes of first FEC codewords. Interleaving or multiplexing is performed on the n lane data streams to obtain the m first encoded data streams, where each first data stream is obtained by interleaving v lanes of first FEC codewords, and v is exactly divisible by u. First, receiving processing such as clock and data recovery (Clock and Data Recovery, CDR), equalization, and demodulation is performed on the m first encoded data streams. Then, interleaving alignment, convolutional interleaving (convolutional interleaving), and inner-code encoding are sequentially and separately performed on the m first encoded data streams to obtain m second encoded data streams. Further, data processing is performed on a data stream after inner-code encoding, and then a processed data stream is sent to a channel transmission medium for transmission. The data processing may include modulation mapping (mapping), channel interleaving (channel interleaving), and the like.

It should be noted that, a convolutional interleaving operation is specifically disordering input bits and then sending the bits to an inner-code encoder for the inner-code encoding. The interleaving alignment is specifically dividing a boundary in each first encoded data stream based on a specific requirement, and sending bits in the first encoded data stream to a storage unit in a convolutional interleaver in batches based on this division manner, so that a bit sequence sent in each batch to the storage unit in the convolutional interleaver satisfies a design requirement. The following describes the design requirement in detail. In other words, the interleaving alignment operation may be considered as a preparation for the convolutional interleaving, to ensure that the convolutional interleaving is performed on a premise of data alignment designed in this application.

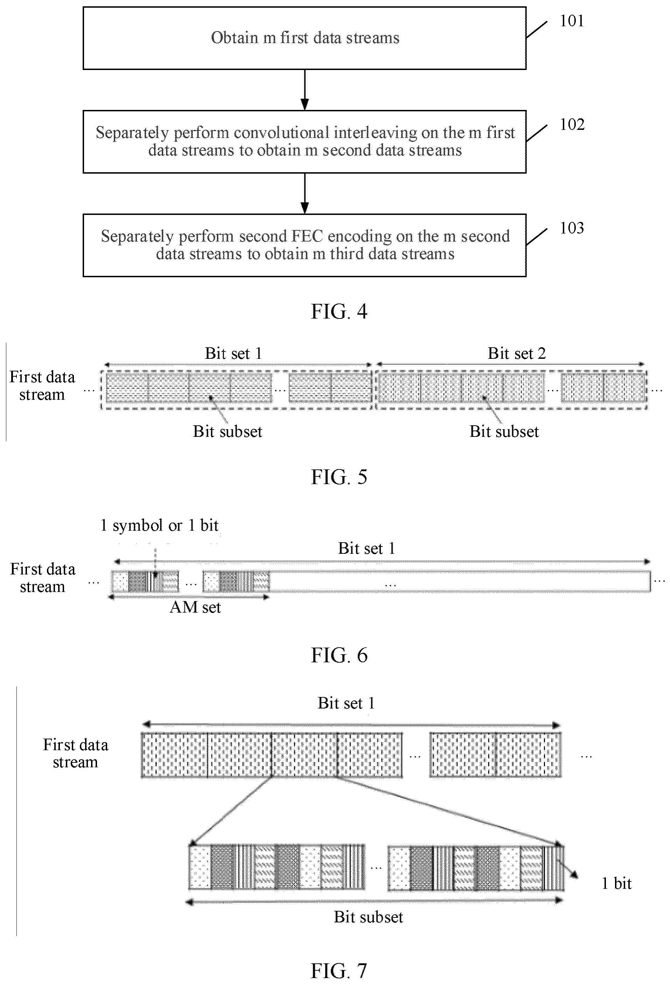

FIG. 4 is a schematic flowchart of a data processing method according to an embodiment of this application. The data processing method may be specifically performed by a transmitter processing module 02.

101: Obtain m first data streams.

In this embodiment, first FEC encoding, namely, outer-code encoding, is performed on all the m first data streams, where m is an integer greater than 1. It should be noted that the m first data streams are obtained by multiplexing n lane data streams, the first FEC encoding is performed on each lane data stream, n is an integer multiple of m, and a codeword obtained through the first FEC encoding is referred to as a first FEC codeword. In a possible implementation, a transmitter device 01 periodically inserts an alignment marker (Alignment marker, AM) into to-be-sent data, and performs the first FEC encoding. Then, after u lanes of first FEC codewords are interleaved, the first FEC codewords are allocated to n PCS lanes, to form the n lane data streams. After the n lane data streams are multiplexed by using a physical media attachment (Physical Medium Attachment, PMA) sublayer, m lanes of first data streams obtained by interleaving v lanes of first FEC codewords are obtained, and the m lanes of first data streams are sent to the transmitter processing module 02 through an AUI-m interface. m lanes in the AUI-m interface are respectively used to transmit the m first data streams. It should be understood that each first data stream is a data stream on which interleaving alignment is completed. The following describes features of the first data stream obtained through the interleaving alignment.

FIG. 5 is a diagram of a first structure of a first data stream according to an embodiment of this application. As shown in FIG. 5, each first data stream includes a plurality of consecutive bit sets, for example, a bit set 1, a bit set 2, .... Each of the bit sets includes t bit subsets, and t is an integer greater than 1. Each bit subset includes d bits, d=v×s, and v is an integer greater than 1. s indicates a quantity of bits included in each symbol of a first codeword obtained through first FEC encoding, and s is an integer greater than or equal to 1. For example, when the first FEC codeword is RS (544, 514), s=10. It should be understood that the bits in each bit subset are from v symbols, and the v symbols are respectively from v first codewords. In other words, one symbol is selected from each of the v first codewords to form a bit subset. It should be understood that each first data stream is obtained by interleaving v lanes of first codewords, and each lane of first codewords includes a plurality of first codewords. The v first codewords herein are respectively from the v lanes of first codewords. This is equivalent to that the v first codewords are obtained by selecting one codeword from each of the v lanes of first codewords. Therefore, L=v×t×s consecutive bits in the bit set are from the v first codewords. It should be understood that this is equivalent to that t symbols from a same first FEC codeword are respectively located in t bit subsets. It should be further understood that two consecutive bit sets are respectively from different first FEC codewords. For example, bits in the bit set 1 are from v first codewords obtained through the first FEC encoding, and bits in the bit set 2 are from other v first codewords obtained through the first FEC encoding.

It should be noted that the bit set and the bit subset are merely concepts introduced for ease of description. In actual application, each first data stream is a whole and is not divided. It should be further noted that, in some possible scenarios, the bit set may also be referred to as an interleaving block, and the bit subset may also be referred to as an interleaving sub-block. Names of the bit set and the bit subset are not specifically limited herein.

FIG. 6 is a diagram of a second structure of a first data stream according to an embodiment of this application. As shown in FIG. 6, a bit set 1 in the first data stream is used as an example. An AM set is placed starting from a start boundary of the bit set 1. It should be understood that, because each lane data stream includes a plurality of AMs, and the n lane data streams are multiplexed to obtain the m first data streams, an AM set in a bit set of the first data stream includes n/m AMs, and the AM set is obtained by multiplexing/interleaving the n/m AMs. Specific data may be obtained based on a specific multiplexing manner used when the n lane data streams are multiplexed into the m first data streams and specific data of the AM. In other words, a distribution manner or an arrangement manner of the n/m AMs in the AM set is not limited in this application. For example, n/m=4, and the n lane data streams are multiplexed in a manner of symbol multiplexing to obtain the m first data streams. A 4i^{th} symbol in the AM set is from an AM 0, a (4i+1)^{th} symbol in the AM set is from an AM 1, a (4i+2)^{th} symbol in the AM set is from an AM 2, and a (4i+3)^{th} symbol in the AM set is from an AM 3, where i is an integer. As shown in FIG. 6, different patterns in blocks indicate that symbols are from different AMs. For another example, n/m=4, and the n lane data streams are multiplexed in a manner of bit multiplexing to obtain the m first data streams. A 4i^{th} bit in the AM set is from an AM 0, a (4i+1)^{th} bit in the AM set is from an AM 1, a (4i+2)^{th} bit in the AM set is from an AM 2, and a (4i+3)^{th} bit in the AM set is from an AM 3, where i is an integer. As shown in FIG. 6, different patterns in blocks indicate that bits are from different AMs.

It should be further understood that the first data stream includes a plurality of AM sets, and an integer quantity of bit sets are included between start positions of every two adjacent AM sets. In other words, in actual application, an AM set is not necessarily placed at a start position of each bit set in the first data stream, and a next AM set may be present at an interval of a plurality of bit sets after the bit set 1.

It should be noted that in this application, a boundary of the bit set is defined by using a start position of the AM set. Therefore, the interleaving alignment operation may be understood as determining a boundary of a corresponding bit set based on at least one AM set. This is equivalent to that, in the first data stream, the boundary position of the bit set is determined by identifying the AM set. In addition, because a length of each bit set is fixed, a boundary of each of other bit sets is determined based on a boundary of one bit set. Further, a boundary of each bit subset in the bit set may be determined based on each bit set whose position is determined.

FIG. 7 is a diagram of a third structure of a first data stream according to an embodiment of this application. As shown in FIG. 7, in a possible implementation, a bit subset of a bit set 1 is used as an example. Every v consecutive bits in the bit subset are respectively from v first codewords. Each block in the bit subset shown in FIG. 7 represents 1 bit, and different patterns in blocks indicate that bits are from different first codewords. In FIG. 7, v=4 is used as an example.

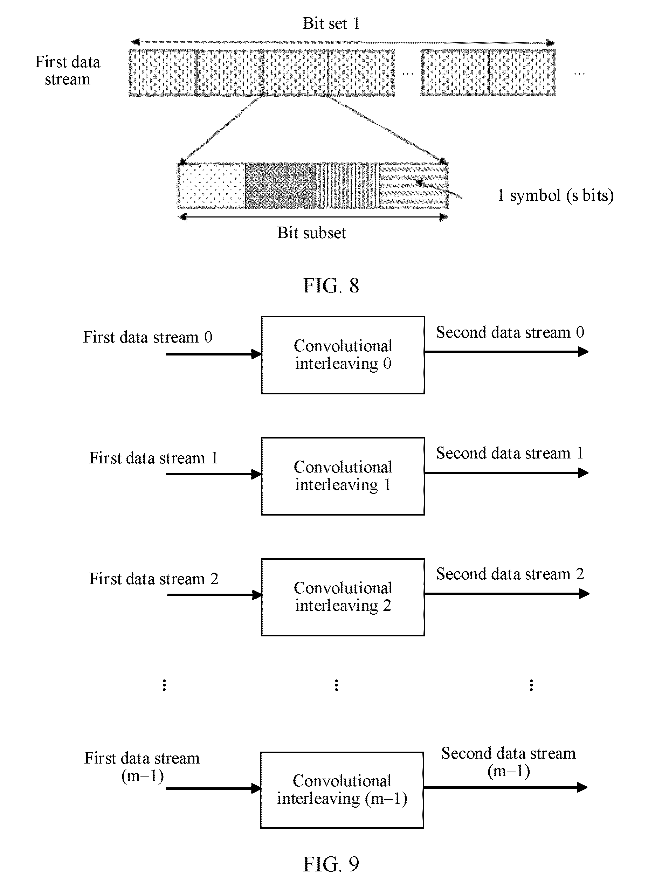

FIG. 8 is a diagram of a fourth structure of a first data stream according to an embodiment of this application. As shown in FIG. 8, in another possible implementation, a bit subset of a bit set 1 is used as an example. Every s consecutive bits in the bit subset are from a same first codeword. Each block in the bit subset shown in FIG. 8 represents s bits, that is, one symbol, and different patterns in blocks indicate that symbols are from different first codewords.

102: Separately perform convolutional interleaving on the m first data streams to obtain m second data streams.

FIG. 9 is a diagram of separately performing convolutional interleaving on m first data streams according to an embodiment of this application. As shown in FIG. 9, the convolutional interleaving may be separately performed on the m first data streams via m convolutional interleavers, and a second data stream with a disordered data sequence may be obtained through the convolutional interleaving on each first data stream. It should be noted that, in this embodiment, each convolutional interleaver performs the convolutional interleaving on an input first data stream in a similar manner. Specifically, each convolutional interleaver includes p delay lines (delay line), and each convolutional interleaver delays the input first data stream based on the p delay lines to obtain a second data stream. p is an integer greater than 1, quantities of storage units included in the delay lines are different from each other, a delay line with a smallest quantity of storage units includes zero storage units, a difference between quantities of storage units in every two adjacent delay lines is Q, and Q is an integer greater than or equal to 1. Each storage unit is configured to store d bits, in other words, each storage unit is configured to store bits in one bit subset. In other words, the p delay lines respectively correspond to p delay values, and the delay values include 0 bits, V bits, 2V bits, ..., and (p-1)V bits, where V=Q×d. A larger quantity of bits included in a delay value of a delay line indicates a longer delay (also referred to as a latency) caused by the delay line on a data stream. It should be understood that, when a delay line includes no storage unit, a delay caused by the delay line is zero bits, in other words, transparent transmission without a delay is performed.

It should be noted that bits in each first data stream are sequentially input into the p delay lines based on sequence numbers of the p delay lines, and d bits in one bit subset are input at a time into each delay line and d bits are output at a time from each delay line. The parameter Q is selected, so that p×d consecutive bits in each second data stream are from v×p first codewords. Subsequently, inner-code encoding is performed on every p×d consecutive bits in each second data stream to obtain an inner-code codeword, so that a bit in each inner-code codeword can be mapped to outer-code codewords of a maximum quantity. In this way, performance of a concatenated code is optimal.

The following describes a specific structure of the convolutional interleaver with reference to the accompanying drawings.

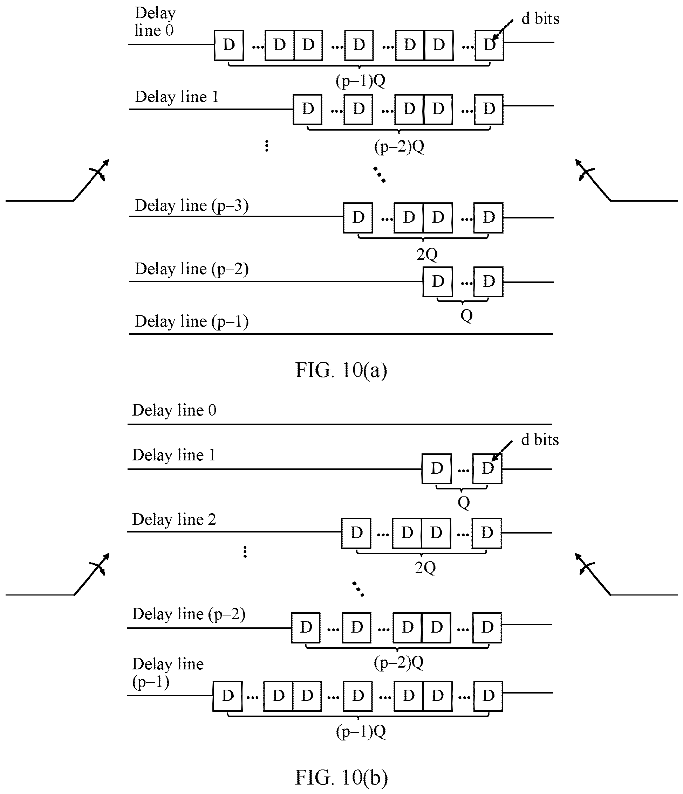

FIG. 10(a) is a diagram of a first structure of a convolutional interleaver according to an embodiment of this application. As shown in FIG. 10(a), quantities of storage units in p delay lines sequentially decrease based on sequence numbers of the p delay lines. In other words, a delay line 0 has (p-1)×Q storage units, Q storage units are sequentially decreased from each delay line, and a delay line (p-1) has zero storage units. In this implementation, the parameters p, Q, and d are selected to satisfy (p × Q + 1) ≥ t, so that p×d consecutive bits in the second data stream are from v×p first codewords.

FIG. 10(b) is a diagram of a second structure of a convolutional interleaver according to an embodiment of this application. As shown in FIG. 10(b), quantities of storage units in p delay lines sequentially increase based on sequence numbers of the p delay lines. In other words, a delay line 0 has zero storage units, Q storage units are sequentially increased for each delay line, and a delay line (p-1) has (p-1)×Q storage units. In this implementation, the parameters p, Q, and d are selected to satisfy (p × Q-1) ≥ t, so that p×d consecutive bits in the second data stream are from v×p first codewords.

It should be noted that, at a same moment, an input switch (switch) and an output switch of the convolutional interleaver are in a same delay line. After d bits are input at a time into a current delay line and d bits are output at a time from the current delay line, positions of the switches change to a next delay line, to ensure that the bits in each first data stream are sequentially input into the p delay lines based on the sequence numbers of the p delay lines, and p×d consecutive bits in the first data stream include d bits output from each delay line. A specific data read/write operation performed by the convolutional interleaver is as follows: d bits are read from a storage unit that is closest to an output port and that is in the current delay line. d bits stored in each storage unit in the current delay line are transferred to a next storage unit. Next, d bits are written into a storage unit that is closest to an input port and that is in the current delay line. Then, switching to a next delay line is performed, and the foregoing operations are repeated. The rest can be deduced by analogy.

It should be understood that when same parameters p, Q, and d are used, convolutional interleaving processing in FIG. 10(a) and convolutional interleaving processing in FIG. 10(b) are reverse operations of each other. In other words, when the transmitter processing module uses the convolutional interleaving structure shown in FIG. 10(a), convolutional de-interleaving corresponding to a receiver processing module that corresponds to the transmitter processing module uses the structure shown in FIG. 10(b). Similarly, when the transmitter processing module uses the convolutional interleaving structure shown in FIG. 10(b), convolutional de-interleaving corresponding to a receiver processing module that corresponds to the transmitter processing module uses the structure shown in FIG. 10(a).

It should be further understood that any one of the m convolutional interleavers may use one structure shown in FIG. 10(a) or FIG. 10(b). In actual application, the m convolutional interleavers may all use the structure shown in FIG. 10(a); the m convolutional interleavers may all use the structure shown in FIG. 10(b); or some convolutional interleavers may use the structure shown in FIG. 10(a), and a remaining convolutional interleaver uses the structure shown in FIG. 10(b).

103: Separately perform second FEC encoding on the m second data streams to obtain m third data streams.

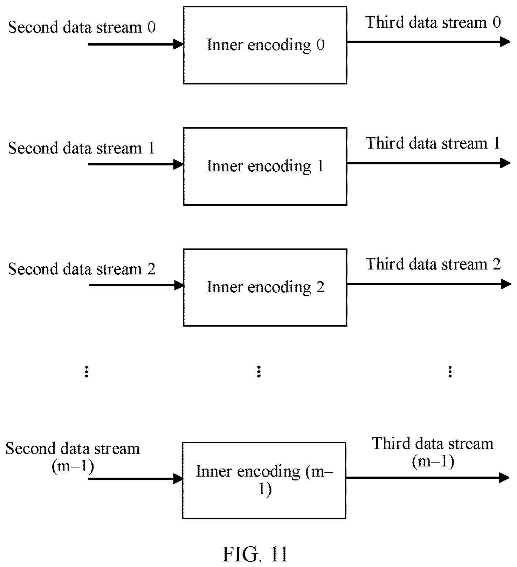

FIG. 11 is a diagram of performing second FEC encoding on m second data streams according to an embodiment of this application. As shown in FIG. 11, the second FEC encoding, namely, the inner-code encoding mentioned above, is separately performed on the m second data streams. Specifically, w×p×d consecutive bits in each second data stream that are output from the p delay lines w times in a round robin manner are used as information data of an inner-code codeword, and M bits of redundant data are added through inner-code encoding, to obtain an inner-code codeword whose code length is N = K + M. Information of K = p × w × d information bits in each second codeword obtained through the second FEC encoding is from a maximum of p×v different first codewords. Especially when w=1, the concatenated code can achieve optimal performance.

It should be noted that, an inner-code encoded data stream undergoes data processing, and then is sent to a channel transmission medium for transmission. The data processing may include modulation mapping (mapping), channel interleaving (channel interleaving), polarization distribution (polarization distribution), DSP framing (framing), or the like. For example, the data stream after inner-code encoding may be interleaved and then transmitted, to improve a capability of a system to resist a burst error.

In embodiments of this application, for a concatenated FEC-based transmission solution, interleaving alignment needs to be first performed before convolutional interleaving is performed on the first data stream, to determine a boundary of each bit set in the first data stream and a boundary of each bit subset in the bit set. Further, bit subsets are sent as a granularity to each storage unit in a convolutional interleaving operation. In other words, each bit subset includes d bits, and each storage unit is configured to store d bits. The bits in each bit subset are from v symbols, and the v symbols are respectively from v first codewords. In other words, one symbol is selected from each of the v first codewords to form a bit subset. In cooperation with subsequent convolutional interleaving, a complete outer-code codeword symbol may be mapped to an inner-code codeword with a minimum interleaving delay, and an uncorrectable inner-code codeword results in a maximum of one incorrect symbol of an outer-code codeword associated with the inner-code codeword. This avoids error dispersion into a plurality of symbols of the outer-code codeword and improves performance of a concatenated code.

The following further describes a procedure of the data processing method described in FIG. 4 with reference to some specific embodiments.

Embodiment 1: An application scenario is a 1×800G interface, where m=8, v=4, t=68, s=10, and p=3.

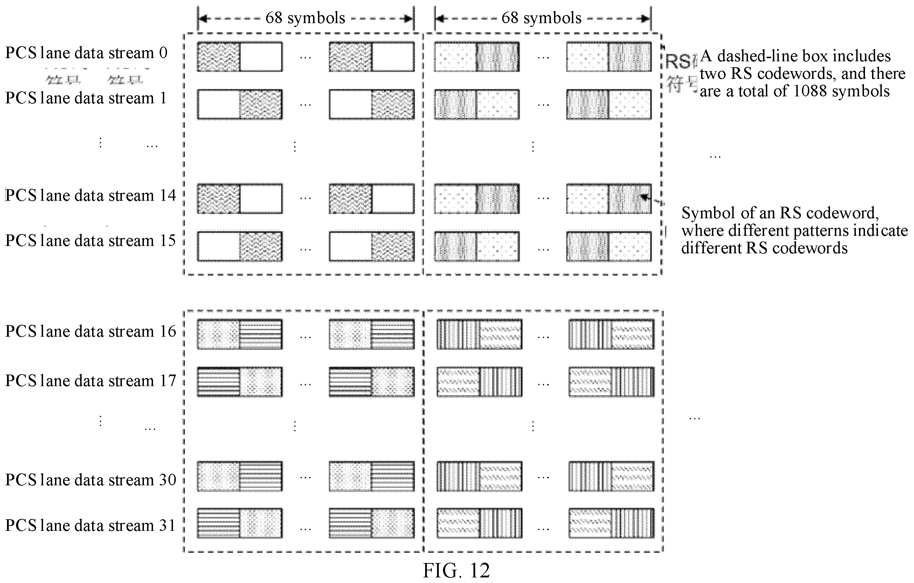

FIG. 12 is a diagram of 32 PCS lane data streams when a transmitter device uses a 1×800G interface. As shown in FIG. 12, when the transmitter device 01 sends a 1×800GE service, in a possible implementation, the transmitter device 01 periodically inserts an AM into a to-be-sent data stream, next performs RS encoding (to be specific, outer-code encoding or first FEC encoding), and then performs interleaving of two lanes of RS codewords to allocate the codewords to 32 PCS lanes, to cause RS codeword arrangement on the 32 PCS lanes to be as shown in FIG. 12. PCS lane data streams 0 to 15 are formed by interleaving two lanes of RS codewords, and PCS lane data streams 16 to 31 are formed by interleaving other two lanes of RS codewords. For example, as shown in FIG. 12, a 1^{st} dashed-line box corresponding to the PCS lane data streams 0 to 15 indicates that the 1^{st} dashed-line box part is obtained by interleaving an RS codeword 1 and an RS codeword 2, and a 2^{nd} dashed-line box corresponding to the PCS lane data streams 0 to 15 indicates that the 2^{nd} dashed-line box part is obtained by interleaving an RS codeword 3 and an RS codeword 4, where the RS codeword 1 and the RS codeword 3 are from one lane of RS codewords, and the RS codeword 2 and the RS codeword 4 are from the other lane of RS codewords. The rest can be deduced by analogy. Similarly, a 1^{st} dashed-line box corresponding to the PCS lane data streams 16 to 31 indicates that an RS codeword 5 and an RS codeword 6 are used for interleaving, and a 2^{nd} dashed-line box corresponding to the PCS lane data streams 16 to 31 indicates that an RS codeword 7 and an RS codeword 8 are used for interleaving, where the RS codeword 5 and the RS codeword 7 are from one lane of RS codewords, and the RS codeword 6 and the RS codeword 8 are from the other lane of RS codewords. The rest can be deduced by analogy.

Therefore, any symbol from the PCS lane data streams 0 to 15 and any symbol from the PCS lane data streams 16 to 31 are not from a same RS codeword. Further, adjacent a=2 symbols in each PCS lane data stream are from different RS codewords, two symbols at a same position in two adjacent PCS lane data streams are from different RS codewords, and 68 consecutive symbols on each PCS lane are from two different RS codewords. The transmitter device 01 multiplexes the 32 PCS lane data streams into eight data streams by using a 32:8 PMA, and sends data to the transmitter processing module 02 through an 800GAUI-8 interface. The transmitter processing module 02 performs receiving processing such as clock recovery, equalization, and demodulation on the eight data streams from the 800GAUI-8 interface, and outputs eight first data streams. Because bidirectional RS interleaving and 32:8 PMA bit multiplexing processing are performed on each lane data stream in the transmitter device 01, each first data stream is obtained by interleaving v=4 lanes of RS codewords.

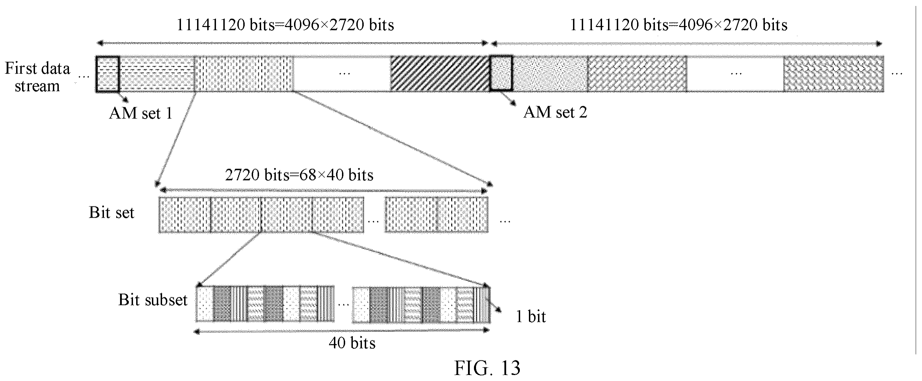

FIG. 13 is a diagram of a fifth structure of a first data stream according to an embodiment of this application. As shown in FIG. 13, *L*₁=11141120 bits, namely, 4096 bit sets are included between start positions of every two AM sets in the first data stream, and each bit set includes 2720 bits. A length of an AM set is four times a length of an AM in a PCS lane data stream. An example in which the length of the AM is 120 bits is used, and the length of the AM set is equal to 4×120=480 bits. Bits in each bit set are obtained by interleaving data from four RS codewords, and bits in two consecutive bit sets are from different RS codewords. Each bit set includes t=68 bit subsets, each bit subset includes 40 bits, and the 40 bits are obtained by interleaving RS symbols respectively obtained from the four RS codewords. In other words, each bit subset includes four RS symbols, the four RS symbols are respectively from different RS codewords, and every four consecutive bits in the bit subset are respectively from four different RS codewords.

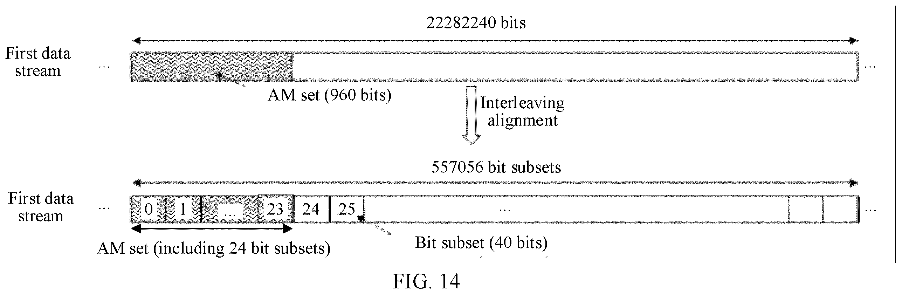

FIG. 14 is a diagram of a sixth structure of a first data stream according to an embodiment of this application. As shown in FIG. 14, in a possible implementation, an AM set in the first data stream is first locked, and then the first data stream is divided by using the AM set as a start, to obtain a plurality of bit subsets, where each bit subset includes d=40 bits. This is equivalent to that each storage unit in a convolutional interleaver is aligned at a granularity of a bit subset. Therefore, this is referred to as interleaving alignment.

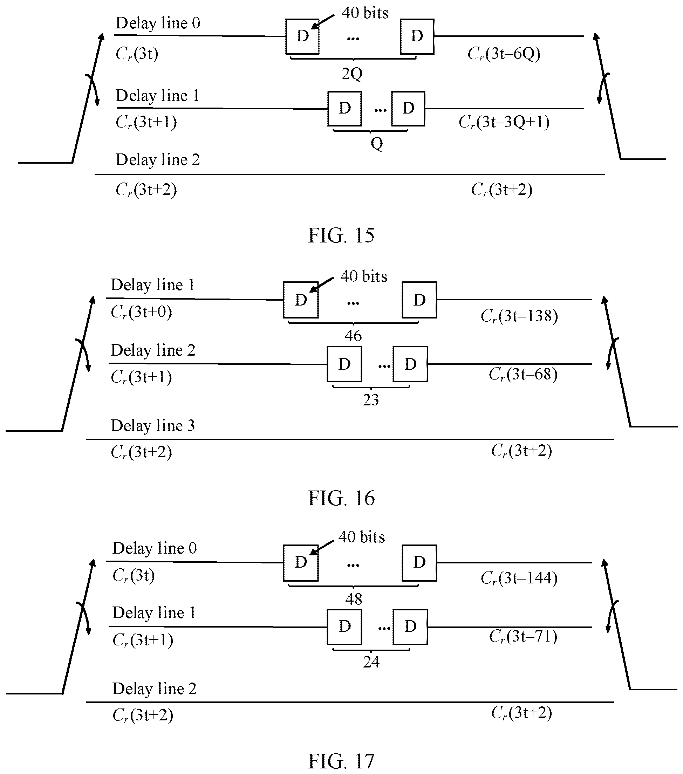

FIG. 15 is a diagram of a third structure of a convolutional interleaver according to an embodiment of this application. As shown in FIG. 15, p=3 delay lines (delay line) are included. The p=3 delay lines respectively include 2Q storage units, Q storage units, and zero storage units, and each storage unit is configured to store one bit subset (d=40 bits). In other words, a delay value of a delay line 0 is 80 × Q bits, a delay value of a delay line 1 is 40 × Q bits, and a delay value of a delay line 2 is 0 bits, that is, no delay occurs.

As shown in FIG. 15, Cᵣ(·) indicates a bit subset in a first data stream r (0 ≤ r ≤ m-1). For example, Cᵣ(3t) indicates a bit subset that is currently input from the first data stream r to the delay line 0, and Cᵣ(3t-6Q) is a bit subset that is output from the delay line 0. Cᵣ(3t+1) indicates a bit subset that is next input from the first data stream r to the delay line 1, and Cᵣ(3t-3Q + 1) is a bit subset that is output from the delay line 1. Cᵣ(3t+2) indicates a bit subset that is then input from the first data stream r to the delay line 2, and Cᵣ(3t+2) is a bit subset that is output from the delay line 2. Cᵣ(3t+3) indicates a bit subset that is subsequently input from the first data stream r to the delay line 0, and Cᵣ(3t-6Q + 3) is a bit subset that is output from the delay line 0. The rest can be deduced by analogy. According to an RS distribution rule in a first FEC encoded data stream, two consecutive bit sets in the first data stream are from different RS codewords, and the bit sets are divided into 68 bit subsets, in other words, bits in a bit subset Cᵣ(A) and a bit subset Cᵣ(A+68) in the first data stream are from different RS codewords. When p × Q + 1 ≥ 68, that is, when Q ≥ 23, a total of 120 bits in Cᵣ(3t-6Q), Cᵣ(3t-3Q + 1), and Cᵣ(3t+2) output from the three delay lines in the convolutional interleaver in a round robin manner may be from 12 different RS codewords.

FIG. 16 is a diagram of a fourth structure of a convolutional interleaver according to an embodiment of this application. As shown in FIG. 16, in a possible implementation, Q = 23 is selected, and a corresponding total interleaving and de-interleaving latency is about 46×40×3=5520 bits. This is equivalent to that a total interleaving and de-interleaving latency is about 52 ns in a 1×800GE service.

FIG. 17 is a diagram of a fifth structure of a convolutional interleaver according to an embodiment of this application. As shown in FIG. 17, to implement the convolutional interleaver by using a low-frequency clock, Q may further be restricted to a multiple of 2, for example, Q=24 is selected. A corresponding total interleaving and de-interleaving latency is 48×40×3=5760 bits. This is equivalent to that a total interleaving and de-interleaving latency is about 54 ns in a 1×800GE service. In corresponding hardware implementation, a clock of about 885 MHz may be used. In each clock, three consecutive bit subsets are respectively input into storage units with a storage bit width of 40 bits in three delay lines, and then one bit subset is read from each of the storage units in the three delay lines. This is equivalent to that a delay unit of a delay line 0 of the convolutional interleaver shown in FIG. 17 is implemented by using a memory whose bit width is 40 bits and whose depth is 48 bits, and a delay unit of a delay line 1 is implemented by using a memory whose bit width is 40 bits and whose depth is 24 bits. Alternatively, a clock of about 442 MHz may be used. In each clock, an i^{th} bit subset and an (i+3)^{th} bit subset in six consecutive bit subsets are output into a storage unit with a storage bit width of 80 bits in a delay line i, and two bit subsets are simultaneously read from each of storage units in three delay lines. This is equivalent to that a delay unit of a delay line 0 of the convolutional interleaver shown in FIG. 17 is implemented by using a memory whose bit width is 80 bits and whose depth is 24 bits, and a delay unit of a delay line 1 is implemented by using a memory whose bit width is 80 bits and whose depth is 12 bits.

Inner-code encoding is separately performed on the foregoing eight second data streams, where a length of information bits used for the inner-code encoding is 120 bits. Specifically, an inner-code encoder separately adds redundancy to a total of 120 bits in three consecutive bit subsets in the second data stream, to obtain a third data stream, where the 120 bits are three bit subsets Cᵣ(3t-6Q), Cᵣ(3t-3Q + 1), and Cᵣ(3t+2) that are output from the three delay lines of the convolutional interleaver at a time in a round robin manner. In this manner, de-convolutional interleaving synchronization may be performed after inner-code synchronization is completed. In a possible implementation, inner-code encoding is performed by using Hamming (128, 120), and 8-bit redundancy is added to 120 consecutive bits in each second data stream to obtain a 128-bit codeword. To make a pre-FEC bit error rate BER corresponding to a post-FEC BER of 1E-15 be about 4.8E-3, performance approach optimal performance of the concatenated FEC-based solution, and a latency of the interleaver be within only 54 ns, the solution of Embodiment 1 is used, and a KP4 RS (544, 514)+Hamming (128, 120) concatenated code is under AWGN.

In Embodiment 1, interleaving alignment and convolutional interleaving are separately performed on eight physical lanes of data streams from the 800GAUI-8 interface. This embodiment has lower complexity in comparison with a conventional technology in which AM locking and convolutional interleaving are separately performed on 32 PCS lanes. In addition, in comparison with a conventional technology in which convolutional interleaving is performed on PCS lane data streams obtained through interleaving of two lanes of RS codewords, this solution in which convolutional interleaving is performed by directly using first data streams obtained through interleaving of four lanes of RS codewords can have a lower latency, so that the concatenated FEC-based transmission solution can be applied to a large quantity of transmission scenarios, and is particularly applicable to a transmission scenario that needs a low transmission latency, for example, a low-latency data center interconnection scenario.

Embodiment 2: An application scenario is a 1×800G interface, where m=4, v=4, t=136, s=10, and p=3.

The transmitter device 01 multiplexes the 32 PCS lane data streams into four data streams by using a 32:4 PMA, and sends data to the transmitter processing module 02 through an 800GAUI-4 interface. The transmitter processing module 02 performs receiving processing such as clock recovery, equalization, and demodulation on the four data streams from the 800GAUI-4 interface, and outputs four first data streams.

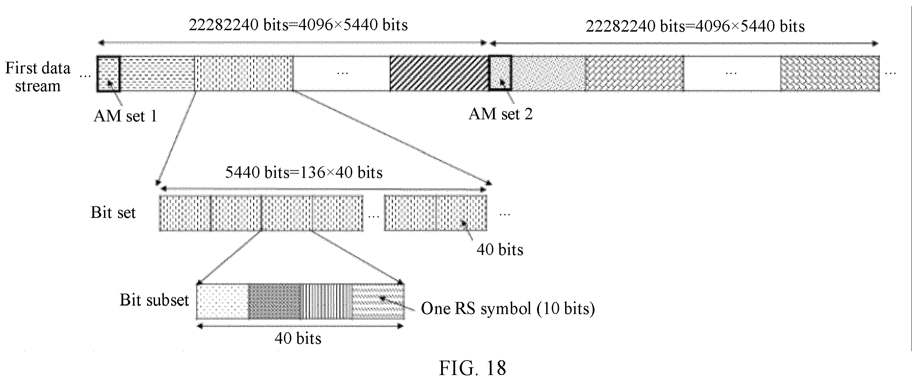

FIG. 18 is a diagram of a seventh structure of a first data stream according to an embodiment of this application. As shown in FIG. 18, L₁=22282240 bits, namely, 4096 bit sets are included between start positions of every two AM sets in the first data stream, and each bit set includes 5440 bits. A length of an AM set is eight times a length of an AM in a PCS lane data stream. An example in which the length of the AM is 120 bits is used, and the length of the AM set is equal to 8×120=960 bits. Bits in each bit set are obtained by interleaving a plurality of RS symbols from four RS codewords, and bits in two consecutive bit sets are from different RS codewords. Each bit set includes 136 bit subsets, each bit subset includes 40 bits, and the 40 bits are obtained by interleaving RS symbols respectively obtained from the four RS codewords. In other words, each bit subset includes four RS symbols, the four RS symbols are respectively from different RS codewords, and 10 consecutive bits in the bit subset are from a same RS codeword.

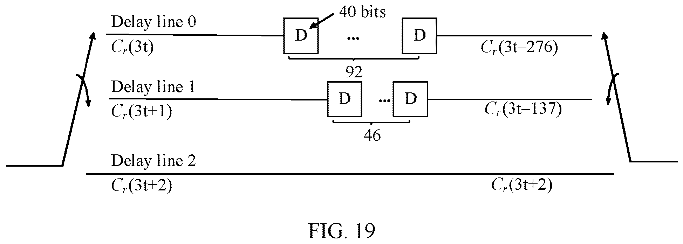

FIG. 19 is a diagram of a sixth structure of a convolutional interleaver according to an embodiment of this application. As shown in FIG. 19, according to an RS distribution rule in a first encoded stream, bits in a bit subset Cᵣ(A) and a bit subset Cᵣ(A+136) in the first data stream are from different RS codewords. When p × Q + 1 ≥ 136, that is, when Q ≥ 45, a total of 120 bits in Cᵣ(3t-6Q), Cᵣ(3t-3Q + 1), and Cᵣ(3t+2) output from three delay lines in the convolutional interleaver in a round robin manner may be from 12 different RS codewords. In addition, to implement the convolutional interleaver by using a lower-frequency clock, Q may further be a multiple of 2 or 4. For example, Q=46. In hardware implementation, a clock of about 1.77 GHz may be used. In each clock, three consecutive bit subsets are respectively input into storage units with a storage bit width of 40 bits in three delay lines, and then one bit subset is read from each of the storage units in the three delay lines. This is equivalent to that a delay unit of a delay line 0 of the convolutional interleaver shown in FIG. 19 is implemented by using a memory whose bit width is 40 bits and whose depth is 92 bits, and a delay unit of a delay line 1 is implemented by using a memory whose bit width is 40 bits and whose depth is 46 bits. Alternatively, a clock of about 885 MHz may be used. In each clock, an i^{th} bit subset and an (i+3)^{th} bit subset in six consecutive bit subsets are output into a storage unit with a storage bit width of 80 bits in a delay line i, and two bit subsets are simultaneously read from each of storage units in three delay lines. This is equivalent to that a delay unit of a delay line 0 of the convolutional interleaver shown in FIG. 19 is implemented by using a memory whose bit width is 80 bits and whose depth is 46 bits, and a delay unit of a delay line 1 is implemented by using a memory whose bit width is 80 bits and whose depth is 23 bits.

In Embodiment 2, interleaving alignment and convolutional interleaving are separately performed on four physical lanes of data streams from the 800GAUI-4 interface. This embodiment has lower complexity in comparison with a conventional technology in which 32 PCS lanes are first restored from the four physical lanes from the 800GAUI-4 interface, and then AM locking and convolutional interleaving are separately performed. In addition, in comparison with a conventional technology in which convolutional interleaving is performed on PCS lane data streams obtained through interleaving of two lanes of RS codewords, this solution in which convolutional interleaving is performed by directly using first data streams obtained through interleaving of four lanes of RS codewords can have a lower latency, so that the concatenated FEC-based transmission solution can be applied to a large quantity of transmission scenarios, and is particularly applicable to a transmission scenario that needs a low transmission latency, for example, a low-latency data center interconnection scenario.

Embodiment 3: An application scenario is a 1600GbE scenario, where m=8, v=4, t=68, s=10, and p=3.

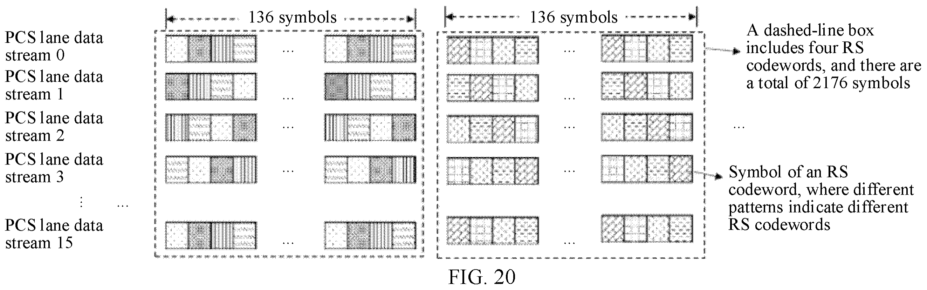

FIG. 20 is a diagram of 16 PCS lane data streams in a 1600GbE scenario. As shown in FIG. 20, the transmitter device 01 periodically inserts an AM into a to-be-sent data stream, next performs RS encoding (to be specific, outer-code encoding or first FEC encoding), and then performs interleaving of four lanes of RS codewords to allocate the codewords to 16 PCS lanes, to cause RS codeword arrangement on the 16 PCS lanes to be as shown in FIG. 20. Adjacent a=4 symbols in each PCS lane data stream are from different RS codewords, two symbols at a same position in two adjacent PCS lane data streams are from different RS codewords, and 136 consecutive symbols on each PCS lane are from four RS codewords. The transmitter device 01 performs symbol multiplexing on the 16 PCS lane data streams by using a 16:8 PMA, and then sends data to the transmitter processing module 02 through an 1600GAUI-8 interface. The transmitter processing module 02 performs receiving processing such as clock recovery, equalization, and demodulation on eight data streams from the 1600GAUI-8 interface, and outputs eight first data streams.

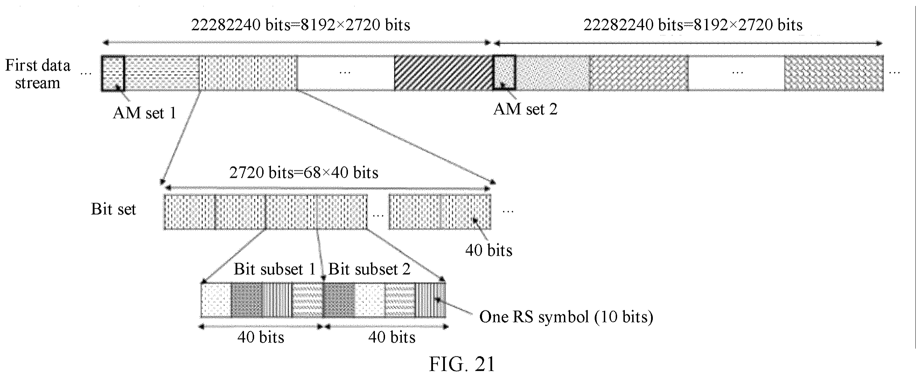

FIG. 21 is a diagram of an eighth structure of a first data stream according to an embodiment of this application. As shown in FIG. 21, L₁=22282240 bits, namely, 8192 bit sets are included between start positions of every two AM sets in the first data stream, and each bit set includes 2720 bits. A length of an AM set is two times a length of an AM in a PCS lane data stream. An example in which the length of the AM is 120 bits is used, and the length of the AM set is equal to 2×120=240 bits. Bits in each bit set are obtained by interleaving a plurality of RS symbols from four RS codewords, and bits in two consecutive bit sets are from different RS codewords. Each bit set includes t=68 bit subsets, each bit subset includes 40 bits, and the 40 bits are obtained by interleaving RS symbols respectively obtained from the four RS codewords. In other words, each bit subset includes four RS symbols, the four RS symbols are respectively from different RS codewords, and 10 consecutive bits in the bit subset are from a same RS codeword.

In Embodiment 3, the convolutional interleaver shown in FIG. 15 may be used. According to an RS distribution rule in a first encoded stream, bits in a bit subset Cᵣ(A) and a bit subset Cᵣ(A+68) in the first data stream are from different RS codewords. In this case, when p × Q + 1 ≥ 68, that is, when Q ≥ 23, a total of 120 bits in Cᵣ(3t-6Q), Cᵣ(3t-3Q + 1), and Cᵣ(3t+2)output from the three delay lines in the convolutional interleaver in a round robin manner may be from 12 different RS codewords. In addition, to implement the convolutional interleaver by using a lower-frequency clock, Q may further be selected as a multiple of 2 or 4. For example, a specific implementation of the convolutional interleaver when Q=24 is shown in FIG. 17. A corresponding total interleaving and de-inerleaving latency is 48×40×3=5760 bits. This is equivalent to that a total interleaving and de-interleaving latency is about 27 ns in a 1×1600GE service.

In hardware implementation, a clock of about 1.77 GHz may be used. In each clock, three consecutive bit subsets are respectively input into storage units with a storage bit width of 40 bits in three delay lines, and then one bit subset is read from each of the storage units in the three delay lines. This is equivalent to that a delay unit of a delay line 0 of the convolutional interleaver shown in FIG. 17 is implemented by using a memory whose bit width is 40 bits and whose depth is 48 bits, and a delay unit of a delay line 1 is implemented by using a memory whose bit width is 40 bits and whose depth is 24 bits. Alternatively, a clock of about 885 MHz may be used. In each clock, an i^{th} bit subset and an (i+3)^{th} bit subset in six consecutive bit subsets are output into a storage unit with a storage bit width of 80 bits in a delay line i, and two bit subsets are simultaneously read from each of storage units in three delay lines. This is equivalent to that a delay unit of a delay line 0 of the convolutional interleaver shown in FIG. 17 is implemented by using a memory whose bit width is 80 bits and whose depth is 24 bits, and a delay unit of a delay line 1 is implemented by using a memory whose bit width is 80 bits and whose depth is 12 bits. Alternatively, a clock of about 442.5 MHz may be used. In each clock, an i^{th} bit subset, an (i+3)^{th} bit subset, an (i+6)^{th} bit subset, and an (i+9)^{th} bit subset in 12 consecutive bit subsets are output into a storage unit with a storage bit width of 160 bits in a delay line i, and four bit subsets are simultaneously read from each of storage units in three delay lines. This is equivalent to that a delay unit of a delay line 0 of the convolutional interleaver shown in FIG. 17 is implemented by using a memory whose bit width is 160 bits and whose depth is 12 bits, and a delay unit of a delay line 1 is implemented by using a memory whose bit width is 160 bits and whose depth is 6 bits.

In Embodiment 3, interleaving alignment and convolutional interleaving are separately performed on eight physical lanes of data streams from the 1600GAUI-8 interface. This embodiment has lower complexity in comparison with a conventional technology in which 16 PCS lanes are first restored from the eight physical lanes from the 1600GAUI-8 interface, and then AM locking and convolutional interleaving are separately performed.

It should be noted that, in actual application, after interleaving alignment is completed, the transmitter processing module may further first multiplex m first data streams and then perform convolutional interleaving, so that after a rate of a single physical lane of an AUI-m interface is increased, subsequent convolutional interleaving and encoding can keep unchanged. The following describes this implementation.

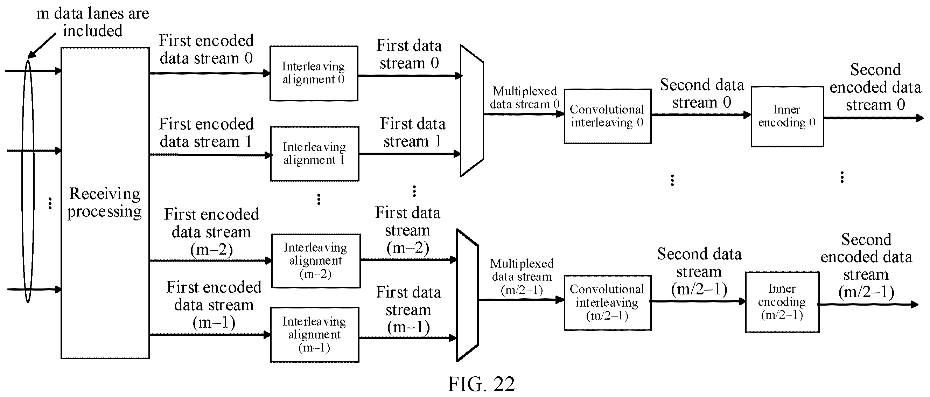

FIG. 22 is another diagram of data processing of a transmitter processing module according to an embodiment of this application. As shown in FIG. 22, after performing interleaving alignment on m first encoded data streams to obtain m first data streams, the transmitter processing module first multiplexes the m first data streams to obtain m/2 multiplexed data streams, and then separately performs convolutional interleaving on the m/2 multiplexed data streams to obtain m/2 second data streams. Further, inner-code encoding is performed on the m/2 second data streams to obtain m/2 second encoded data streams.

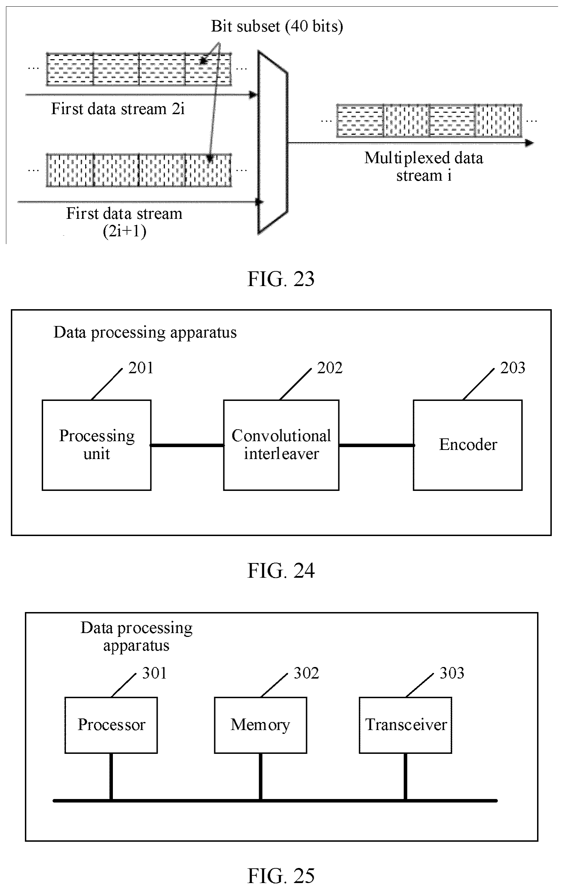

FIG. 23 is a diagram of multiplexing first data streams according to an embodiment of this application. As shown in FIG. 23, a multiplexing operation is to multiplex every two first data streams into one multiplexed data stream. Specifically, one bit subset is output from two first data streams to one multiplexed data stream in a round robin manner, in other words, two consecutive bit subsets in the multiplexed data stream are respectively from a first data stream 2i and a first data stream (2i+1).

The following describes a data processing apparatus provided in embodiments of this application.

FIG. 24 is a diagram of a structure of a data processing apparatus according to an embodiment of this application. As shown in FIG. 24, the data processing apparatus includes a processing unit 201, a convolutional interleaver 202, and an encoder 203. The processing unit 201 is configured to perform an operation of step 101. The convolutional interleaver 202 is configured to perform an operation of step 102. The encoder 203 is configured to perform an operation of step 103. For a specific operation, refer to related descriptions of the foregoing data processing method. Details are not described herein again.

It should be understood that the apparatus provided in this application may alternatively be implemented in another manner. For example, division into the units in the foregoing apparatus is merely logical function division and may be other division in actual implementation. For example, a plurality of units or components may be combined or integrated into another system. In addition, functional units in embodiments of this application may be integrated into one physical unit, may be independent physical units, or two or more functional units may be integrated into one physical unit. The integrated unit may be implemented in a form of hardware, or may be implemented in a form of a software functional unit.

FIG. 25 is a diagram of another structure of a data processing apparatus according to an embodiment of this application. As shown in FIG. 25, the data processing apparatus includes a processor 301, a memory 302, and a transceiver 303. The processor 301, the memory 302, and the transceiver 303 are interconnected through lines. The memory 302 is configured to store program instructions and data. Specifically, the transceiver 303 is configured to perform data receiving and sending operations. The processor 301 is configured to perform an operation of the foregoing data processing method. In a possible implementation, the processor 301 may include the processing unit 201, the convolutional interleaver 202, and the encoder 203 shown in FIG. 24.

It should be noted that the processor shown in FIG. 24 may be a general-purpose central processing unit (Central Processing Unit, CPU), a general-purpose processor, a digital signal processor (DSP), an application-specific integrated circuit (ASIC), a field programmable gate array (FPGA) or another programmable logic device, a transistor logic device, a hardware component, or any combination thereof. The memory shown in FIG. 24 may store an operating system and another application program. When the technical solutions provided in embodiments of this application are implemented by software or firmware, program code used for implementing the technical solutions provided in embodiments of this application is stored in the memory and is executed by the processor. In an embodiment, the processor may include the memory inside. In another embodiment, the processor and the memory are two independent structures.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

A person of ordinary skill in the art may understand that all or a part of the steps in the foregoing embodiments may be implemented by hardware or a program instructing related hardware. The program may be stored in a computer-readable storage medium. The storage medium mentioned above may be a read-only memory, a random access memory, or the like. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

When the software is used for the implementation, all or a part of the method steps described in the foregoing embodiments may be implemented in a form of a computer program product. The computer program product includes one or more computer instructions. When the computer program instructions are loaded and executed on a computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid state disk Solid State Disk (SSD)), or the like.

## Claims

1. A data processing method, comprising:
obtaining m first data streams, wherein m is an integer greater than 1, each of the first data streams is obtained by interleaving v lanes of first codewords obtained through first forward error correction FEC encoding, each of the first data streams comprises a plurality of consecutive bit sets, each of the bit sets comprises t bit subsets, t is an integer greater than 1, each of the bit subsets comprises d bits, d=v×s, v is an integer greater than 1, s indicates a quantity of bits comprised in each symbol in the first codeword, s is an integer greater than or equal to 1, the bits in each of the bit subsets are from v symbols, the v symbols are respectively from v first codewords, and the v first codewords are respectively from the v lanes of first codewords; and
separately delaying the m first data streams based on p delay lines to obtain m second data streams, wherein p is an integer greater than 1, quantities of storage units comprised in the delay lines are different from each other, a delay line with a smallest quantity of storage units comprises zero storage units, a difference between quantities of storage units in every two adjacent delay lines is Q, Q is an integer greater than or equal to 1, each storage unit is configured to store d bits, bits in each of the first data streams are sequentially input into the p delay lines based on sequence numbers of the p delay lines, and d bits in one bit subset are input at a time into each delay line and d bits are output at a time from each delay line.

2. The method according to claim 1, wherein p×d consecutive bits in each of the second data streams are from v×p first codewords.

3. The method according to claim 1 or 2, wherein a delay line with a largest sequence number in the p delay lines comprises zero storage units, and (p × Q + 1) ≥ t.

4. The method according to claim 1 or 2, wherein a delay line with a smallest sequence number in the p delay lines comprises zero storage units, and (p × Q- 1) ≥ t.

5. The method according to any one of claims 1 to 4, wherein Q is a multiple of 2.

6. The method according to any one of claims 1 to 5, wherein the m first data streams are obtained by multiplexing n lane data streams, n is an integer multiple of m, the first FEC encoding is performed on each of the lane data streams, each of the lane data streams comprises a plurality of alignment markers AMs, each of the first data streams comprises a plurality of AM sets, each of the AM sets comprises n/m AMs, and an integer quantity of bit sets is comprised between start positions of every two adjacent AM sets.

7. The method according to claim 6, wherein obtaining the m first data streams comprises:
performing interleaving alignment on the first data stream based on at least one AM set, to determine a boundary position of each of the bit sets in the first data stream.

8. The method according to any one of claims 1 to 7, wherein the plurality of bit sets comprise a first bit set and a second bit set that are adjacent to each other, bits in the first bit set are from v first codewords obtained through the first FEC encoding, and bits in the second bit set are from other v codewords obtained through the first FEC encoding.

9. The method according to any one of claims 1 to 8, wherein every v consecutive bits in the bit subset are respectively from v first codewords, or every s consecutive bits in the bit subset are from a same first codeword.

10. The method according to any one of claims 1 to 9, wherein m=8, v=4, t=68, s=10, p=3, and Q=23 or 24; or m=4, v=4, t=136, s=10, p=3, and Q=46.

11. The method according to any one of claims 1 to 10, wherein after obtaining a total of m second data streams, the method further comprises:
separately performing second FEC encoding on the m second data streams to obtain m third data streams, wherein K information bits in each second codeword obtained through the second FEC encoding are from a maximum of p×v different first codewords, and K is an integer multiple of p×d.

12. A data processing apparatus, comprising a processing unit and a convolutional interleaver, wherein
the processing unit is configured to obtain m first data streams, wherein m is an integer greater than 1, each of the first data streams is obtained by interleaving v lanes of first codewords obtained through first forward error correction FEC encoding, each of the first data streams comprises a plurality of consecutive bit sets, each of the bit sets comprises t bit subsets, t is an integer greater than 1, each of the bit subsets comprises d bits, d=v×s, v is an integer greater than 1, s indicates a quantity of bits comprised in each symbol in the first codeword, s is an integer greater than or equal to 1, the bits in each of the bit subsets are from v symbols, the v symbols are respectively from v first codewords, and the v first codewords are respectively from the v lanes of first codewords; and
the convolutional interleaver is configured to separately delay the m first data streams based on p delay lines to obtain m second data streams, wherein p is an integer greater than 1, quantities of storage units comprised in the delay lines are different from each other, a delay line with a smallest quantity of storage units comprises zero storage units, a difference between quantities of storage units in every two adjacent delay lines is Q, Q is an integer greater than or equal to 1, each storage unit is configured to store d bits, bits in each of the first data streams are sequentially input into the p delay lines based on sequence numbers of the p delay lines, and d bits in one bit subset are input at a time into each delay line and d bits are output at a time from each delay line.

13. The data processing apparatus according to claim 12, wherein p×d consecutive bits in each of the second data streams are from v×p first codewords.

14. The data processing apparatus according to claim 12 or 13, wherein a delay line with a largest sequence number in the p delay lines comprises zero storage units, and (p × Q + 1) ≥ t.

15. The data processing apparatus according to claim 12 or 13, wherein a delay line with a smallest sequence number in the p delay lines comprises zero storage units, and (p × Q- 1) ≥ t.

16. The data processing apparatus according to any one of claims 12 to 15, wherein Q is a multiple of 2.

17. The data processing apparatus according to any one of claims 12 to 16, wherein the m first data streams are obtained by multiplexing n lane data streams, n is an integer multiple of m, the first FEC encoding is performed on each of the lane data streams, each of the lane data streams comprises a plurality of alignment markers AMs, each of the first data streams comprises a plurality of AM sets, each of the AM sets comprises n/m AMs, and an integer quantity of bit sets is comprised between start positions of every two adjacent AM sets.

18. The data processing apparatus according to claim 17, wherein the processing unit is specifically configured to:
perform interleaving alignment on the first data stream based on at least one AM set, to determine a boundary position of each of the bit sets in the first data stream.

19. The data processing apparatus according to any one of claims 12 to 18, wherein the plurality of bit sets comprise a first bit set and a second bit set that are adjacent to each other, bits in the first bit set are from v first codewords obtained through the first FEC encoding, and bits in the second bit set are from other v codewords obtained through the first FEC encoding.

20. The data processing apparatus according to any one of claims 12 to 19, wherein every v consecutive bits in the bit subset are respectively from v first codewords, or every s consecutive bits in the bit subset are from a same first codeword.

21. The data processing apparatus according to any one of claims 12 to 20, wherein m=8, v=4, t=68, s=10, p=3, and Q=23 or 24; or m=4, v=4, t=136, s=10, p=3, and Q=46.

22. The data processing apparatus according to any one of claims 12 to 21, wherein the data processing apparatus further comprises an encoder, wherein the encoder is configured to:
separately perform second FEC encoding on the m second data streams to obtain m third data streams, wherein K information bits in each second codeword obtained through the second FEC encoding are from a maximum of p×v different first codewords, and K is an integer multiple of p×d.
